(19) Europäisches Patentamt
European Patent Office
Office européen des brevets

(11) **EP 1 548 768 B1**

(12) **EUROPEAN PATENT SPECIFICATION**

(45) Date of publication and mention
of the grant of the patent:
**22.02.2012 Bulletin 2012/08**

(51) Int Cl.:
*H03H 3/04* (2006.01)          *H01G 5/14* (2006.01)
*H03H 9/02* (2006.01)          *H03H 9/17* (2006.01)
*H03H 3/02* (2006.01)

(21) Application number: **04078526.3**

(22) Date of filing: **24.12.2004**

(54) **Micromachined film bulk acoustic resonator**

Mikrostrukturierter Dünnfilmresonator

Résonateur à couche mince à micro-usinage

(84) Designated Contracting States:
**AT BE BG CH CY CZ DE DK EE ES FI FR GB GR HU IE IS IT LI LT LU MC NL PL PT RO SE SI SK TR**

(30) Priority: **24.12.2003 EP 03447311**
**29.12.2003 US 533322 P**

(43) Date of publication of application:
**29.06.2005 Bulletin 2005/26**

(73) Proprietor: **IMEC**
**3001 Leuven (BE)**

(72) Inventors:
• **Tilmans, Hendrikus A.C.**
**6229 XA Maastricht (NL)**
• **Pan, Wanling**
**3001 Leuven (BE)**

(74) Representative: **Bird, Ariane et al**
**Bird Goën & Co NV**
**Klein Dalenstraat 42A**
**3020 Winksele (BE)**

(56) References cited:
EP-A- 0 631 384          EP-A2- 0 963 000
WO-A2-03/069776          DE-A- 10 153 434
US-A- 5 339 051          US-A- 5 747 857
US-A1- 2003 051 550      US-A1- 2004 061 573
US-B1- 6 236 281         US-B1- 6 473 289

**Description**

**Technical field of the invention**

The present invention is related to the field of Micromachined Electro Mechanical Systems (MEMS). More particularly, it relates to the field of RF-MEMS devices related to frequency control applications, such as for instance filters, oscillators, etc, especially to a Film Bulk Acoustic Resonator, a method of making the same and a method of tuning the same.

**Background of the invention**

Radio Frequency (RF) MEMS devices have a broad range of potential applications in military and commercial wireless communication, navigation and sensor systems. Military applications at the K-W band include RF seekers, ground-based radars. Millimeter Wave (MMW) sensors can utilize RF-MEMS devices for components such as antennas (switches and phase shifters), exciters, transmitters, filters, IF/RF receivers.

RF-MEMS devices, though small, can be very complex and commonly encompass multiple interdependent engineering disciplines. Furthermore, the RF-MEMS device performance can be influenced by its environment and packaging. Modelling of these devices is critical to reduce both the time and cost of optimising the final RF-MEMS device or integrated RF-MEMS Microsystems.

Film Bulk Acoustic Resonators (FBAR) devices are micromachined frequency controlling devices working typically in the RF frequency regime and typically in the range of a few hundred MHz up to tens of GHz. FBARs have received considerable interest in the RF microelectronics industry because of their applications in oscillators and filter design. A special interest of FBAR has been found in wireless telecommunication systems, such as mobile phones, WLAN or satellite communications. FBAR has already seen a big share in the personal communications services (PCS) market.

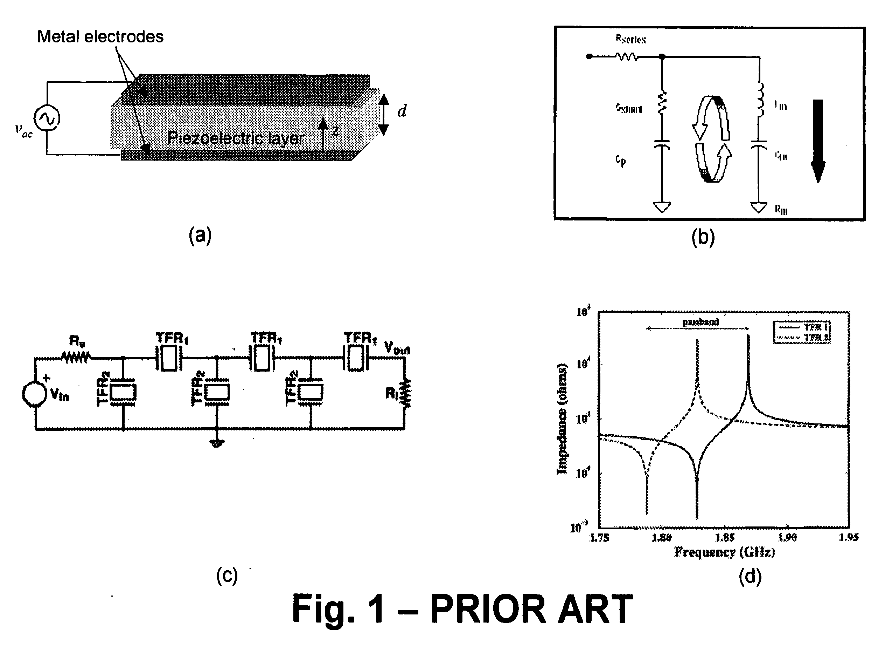

The working principle of an FBAR is the following. An alternating voltage is applied over a thin film layer of a piezoelectric material such as for example AIN or ZnO which is sandwiched between two electrodes, which may for example be metal electrodes (see Fig. 1a). This piezoelectric layer expands and contracts as a result of this applied voltage and an acoustic wave is generated. At a certain frequency, the polarization vector of the piezoelectric layer will be in-phase with the applied electric field. The frequency at which this occurs is defined as the resonant frequency of the FBAR. The resonance frequency mainly depends on the thickness of the piezoelectric layer. To reduce acoustic loss and loading effects, the sandwiched structure is normally suspended in air, or is mounted on reflection layers, which will reflect back the traveling acoustic wave in the interface. A corresponding electric scheme of the FBAR according to the prior art is shown in Fig. 1b.

FBARs have the advantage of small size and a high quality factor, and can be used to build filters with low insertion loss and steep roll-off/on performance. Insertion loss is an indication of loss in transmission. The steepness of roll-off/on is an indication of how 'sharp' the resonant peak is and is an indicator of the precision and effectiveness of frequency control. FBARs furthermore show the advantage of moderate temperature coefficients (TCs) and good power-handling capability and are gaining an increasing amount of application interests.

Both bulk [S. V. Krishnaswamy et al. "Film Bulk Acoustic Wave Resonator Technology" 1990 IEEE Ultrasonics Symposium, pp529-536; J. J. Lutsky et al. "A Sealed Cavity TFR Process for RF Bandpass Filters" IEDM'96; K. M. Lakin "Thin Film Resonators and Filters" 1999 IEEE Ultrasonics Symposium pp.895-906; Markku Ylilammi et al. "Thin Film Bulk Acoutic Wave Filter", IEEE Transactions on UFFC, Vol.49. No.4. April 2002, pp535-539.] and surface [R. Lanz et al. "Surface Micromachined BAW Resonators Based on AIN" 2002 IEEE Ultrasonics Symposium, pp.981-983; Motoaki Hara et al. "Aluminum Nitride Based Thin Film Bulk Acoustic Resonator Using Germanium Sacrificial Layer Etching" The 12th International Conference on Solid State Sensors, Actuators and Microsystems, Boston, June 8-12, 2003. ] micromachined FBARs have been realized.

The resonant frequency of an FBAR is subject to influences or variations such as electromagnetic interference, temperature change, ageing effects, etc. To cope with drifts of different origins and with inhomogeneity during fabrication process, a degree of tuning is desired. Different solutions exist in the art.

In US 5,587,620 a thermal tuning of an FBAR is disclosed, where a heater was used to utilize temperature coefficient of materials. By changing the temperature, the material properties are changed and hence also the resonant frequency is changed.

In US 2001/0017504 electrostrictive material tuning is described. A thin film piezoresonator, which can be tuned over a wide range of RF frequencies, includes a piezo layer between a first electrode layer and a second electrode layer. An electroactive layer of an electrostrictive material, which experiences a mechanical deformation when an electrical voltage is applied, is disposed between a third electrode layer and the second electrode layer.

Adjustment by circuit means has been suggested, which is to add external components to the circuit ["Modeling Piezoelectric and Piezomagnetic Devices and Structures via Equivalent Networks", IEEE UFFC Transactions, Vol.48, No.5, September 2001, pp.1189-1240.].

Frequency tuning of an FBAR oscillator with a discrete low-noise varactor has been reported with a tuning range of 2.5 MHz for a working frequency of 1985 MHz - corresponding to a relative tuning range of about 0.1%. [A.P.S Khanna et al. "A 2GHz Voltage Tunable FBAR Oscillator" 2003 IEEE MTT-S Digest, pp.717-720]. Here an FBAR is fabricated on reflection layers to reduce acoustic loss. Tuning has been achieved by a separate varactor, but a reduced overall Quality factor has been mentioned due to the low quality factor of the varactor. The FBAR and tunable capacitor have separate electrodes and thus induced parasitics. In US Patent 5,166,646 an integrated voltage variable capacitor coupled to the resonator is used. A thin film resonator is coupled to the voltage variable capacitor both of which are formed on a common semiconductor substrate. The tuning capacitor is a device separated from the piezoelectric resonating film.

The most common idea of tuning an FBAR is to connect a series or parallel variable capacitor to it, as suggested by A. Ballato in "Modelling Piezoelectric and Piezomagnetic Devices and Structures via Equivalent Networks", IEEE UFFC Transactions, Vol.48, No.5, September 2001, pp.1189-1240. In Fig. 1c+d an FBAR filter scheme (c) and a plot of FBAR impedance versus signal frequency (d) is shown. However, connecting a series or parallel variable capacitor to the FBAR may deteriorate the quality factor significantly.

In US patent 5,339,051 a micro resonator-oscillator is disclosed. Here an external influence as for instance a temperature or pressure change is measured by the impact they have on the resonator-oscillator frequency of the device. The change of a coupling capacitor, which can correspond to a change of the airgap thickness between constituting elements of the device, is the detection parameter. No controlled external influences can be applied, other than changing the environment of the device and no means for active manipulation of the device as e.g. actuating the device are present. An essential aspect of these devices is a change in the resonator-oscillator frequency due to external to be measured conditions.

In EP 0631384 A1 a piezoelectric acoustic wave device is described, comprising a space between a bottom electrode and a dielectric plate, whereby a capacity-coupling type of resonator is formed. No resonance frequency or tuning of such frequency is discussed. Therefore also no means fot providing such tuning are present.

In US 5,617,065 a filter using an enhanced quality factor resonator is disclosed. Hereby a high quality factor resonator structure is disclosed comprising a resonator layer separated from an electrode by a cavity. Such a device requires a constant resonator frequency and therefore would typically require a stiff resonator layer, which would not easily deform. No tuning of the resonance frequency is discussed.

DE 10153434 (A1) recites a component operating with acoustic waves comprises a piezoelectric layer; electrodes arranged on the piezoelectric layer for producing acoustic waves in the component; and a layer made from a GDE material in mechanical contact with the piezoelectric layer and having a magnetically tuneable elasticity, e.g. for use as a front end filter for a wireless communication device containing the above component. Devices are provided for producing a magnetic field acting on the tuneable layer. The GDE material is made from a metallic glass (metglass), a Fe50Co50/Co50B20 multiple layer system, TbFe2, Tb0.3Dy0.7Fe2, TbxDy1-xFey (in which x = 0.27-0.3, and y = 1.9-1.95), Fe14Nd2B, or a rare earth phosphate.

EP 0963000 (A2) recites a resonator structures of radio communication apparatus. According A micromechanical switch and a resonator are realized in a single combined structure. Combination of switch and resonator structures allows the manufacture of very compact filter and resonator structures needed for multi-system mobile communication means.

WO 03069776 (A2) recites a suspended bulk acoustic wave microresonator comprising a beam which is made from a piezoelectric material. Said beam is solidly connected to a support and is sandwiched between excitation electrodes. The resonator also comprises means of modifying the limiting conditions of the resonator, which is formed by the excited beam, in order to alter the resonance frequency of the microresonator.

**Summary of the invention**

It is an object of the present invention to provide a novel type and method of manufacture and method of tuning of a resonance frequency tunable FBAR device, which has a high quality factor and a high degree of tunability with respect to currently existing FBARs. It is a further object of the present invention to provide FBAR devices with an integrated frequency tuning mechanism. It's another object of the present invention to provide small size tunable FBAR devices which can easily undergo wafer level packaging. Still another object of the present invention is to provide an FBAR device with an improved acoustic isolation.

The above objectives are accomplished by methods and a device according to the present invention.

The present invention provides an FBAR device with a means for internally varying an impedance such as a capacitance and is defined in claim 1. This means for altering an internal impedance of the device may be a means for altering a relative position of components of the device. By altering a relative position of components of the device, a dimension of the device may be changed. The means for altering a relative position of components of the device may be a means for altering the position of any of said top electrode, said bottom electrode, said piezoelectric layer or a material having a dielectric constant greater than 1 and adapted for shifting into or out of a part, i.e. a region, of the device in which an electric field can be generated. This material may preferably be a constituting element in the form of a solid piece or block of material which can controllably be moved. Said means for altering a relative position of components of the device may be a means for shifting said components substantially parallel with said plane of said bottom electrode. The piezoelectric layer may be suspended on one side only and may be part of said cantilever structure.

In one embodiment the device may furthermore comprise a dielectric layer in between the piezoelectric layer and the top electrode. The piezoelectric layer may have a second overlap with the top electrode, the second overlap being defined as the projection of the piezoelectric layer onto the top electrode in a direction substantially perpendicular to the plane of the top electrode.

In embodiments of the present invention the dielectric layer may comprise a gas such as air or vacuum. In an embodiment of the invention, the bottom electrode may comprise a first material and the top electrode may comprise a second material. The first and the second material may be either different from each other or the same material. In a specific embodiment, the first material may be a first metal and the second material may be a second metal, the first and second metal being different from each other.

The device according to the invention may have a Q factor higher than a few hundred and even higher than a few thousand. Furthermore, the device of the invention may have a relative tuning range of between 0.5% and 3%. The relative tuning range may depend on the material used for the piezoelectric layer.

The invention also relates to an FBAR device as defined in claim 14. The piezoelectric layer may be suspended on one side only and may be part of a cantilever structure. The means for varying an internal impedance of the device may be a means for altering a relative position of components of the device. This may comprise moving a material having a dielectric constant greater than 1 into or out of a part of the device in which an electric field can be generated. The material having a dielectric constant greater than A may be in the form of a constituting element in the form of a solid piece or block. The means for varying an internal impedance of the device may be a means for varying the first thickness $t_1$ of the dielectric layer.

The present invention furthermore provides a method for internally tuning a resonance frequency of an FBAR device according to claim 19. Tuning said resonance frequency thereby is a reversibly internally tuning by varying an internal impedance of the device. The change in impedance may be achieved by a variety of methods, e.g., the resonance frequency may be tuned by varying the first overlap between the piezoelectric layer and the bottom electrode and/or if the dielectric layer has a first thickness $t_1$, by varying the thickness $t_1$ of the dielectric layer, e.g. by elastically moving a cantilever beam comprising the piezoelectric layer and/or by introducing a material with a dielectric constant greater than 1. Reversibly internally tuning may comprise altering a relative position of components of the device. The altering a relative position of components of the device may comprise altering a relative position of any of a bottom electrode, a top electrode, a piezoelectric layer or a material having a dielectric constant greater than 1, adapted for shifting into or out of a part, i.e. a region, of the device in which an electric field can be generated. Altering a relative position of components may comprise shifting said components substantially parallel with said plane of the bottom electrode. Said piezoelectric layer may be suspended on one side only and may be part of a cantilever structure. This material may be a constituting element in the form of a solid piece or block of material which can controllably be moved. Varying the first overlap may be performed by moving the piezoelectric layer in a horizontal direction with respect to the bottom electrode, i.e. in a direction substantially parallel with the plane of the bottom electrode. Varying the thickness of the dielectric layer may be performed by moving the top electrode, and hence the piezoelectric layer, in a vertical direction with respect to the bottom electrode, i.e. in a direction substantially perpendicular to the plane of the bottom electrode.

In another embodiment, the device may furthermore comprise a dielectric layer with a second thickness $t_2$ in between the piezoelectric layer and the top electrode and the piezoelectric layer having a second overlap with the top electrode, the second overlap being defined as the projection of the piezoelectric layer onto the top electrode in a direction substantially perpendicular to the plane of the top electrode. Tuning of the resonance frequency may then be achieved by varying the second overlap and/or t2 and/or t1 and/or the first overlap.

Different actuation mechanisms may be used in order to move elements of the FBAR according to the embodiments of the present invention, especially electrodes and piezoelectric layer; these are state of the art and are for instance electrothermal, electromagnetic, electrodynamic, electrostatic, piezoelectric, shape memory and magneto-restrictive actuation.

An advantage of the present invention with respect to the prior art is that tuning the resonance frequency according to the invention may be reversible. This means tuning may be performed in both upwards and downwards directions.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

The present invention also discloses a method and corresponding devices wherein air isolation is used to achieve frequency tuning of FBARs.

The tuning element itself provides acoustic isolation of the FBAR as well and increases the quality factor.

**Brief description of the drawings**

Fig. 1 illustrates prior art solutions for the present invention: (a) is a prior art FBAR and (b) is it's electrical scheme equivalent, (c) represents an FBAR filter scheme and (d) is a plot of FBAR impedance versus signal frequency.

In Fig. 2 the scheme for a variable capacitor tuning of an FBAR is shown according to the prior art, whereby a variable capacitor is put in series with the on itself not tunable FBAR device.

In Fig. 3-9 illustrates a possible processing sequence is depicted for producing an embodiment of the present invention.

Fig. 10 and Fig. 11 represents respectively a side and top view of an embodiment according to the present invention.

Fig. 12 is a SEM picture of an FBAR device according to an embodiment of the present invention.

Fig. 13 and Fig. 14 are respectively a side view and a top view of second embodiment according to the present invention.

In Fig. 15 the equivalent electronic scheme is given for a device according to the present invention.

Fig. 16. Illustrates part of a device according to an embodiment of the present invention.

Fig. 17 and Fig. 18 resp. show S21 and S11 functions in function of signal frequencies for specific embodiment according to the present invention.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The present invention relates to a Film Bulk Acoustic Resonator (FBAR) device which works typically in the RF frequency regime and typically in the range of a few hundred MHz up to tens of GHz. It is to be understood that in all of the embodiments of the present invention, Surface Acoustic Waves are set up in the piezoelectric material to thereby form a resonating device.

The invention provides an FBAR device comprising a means for internally varying an internal impedance and a method for internally tuning the resonance frequency of an FBAR device. This means for altering an internal impedance of the device can be a means for altering an internal capacitance of the device. The means for altering an internal impedance of the device may be means for altering a relative position of components of the device. Altering a relative position of components of the device may result in changing a dimension of the device or may be moving a material having a dielectric constant greater than 1 into or out of a part of the device in which there is an electric field. It comprises both vertical and horizontal movements, i.e. perpendicular or parallel with the plane of the bottom electrode as described below, of components of the device, but also includes movement of dielectric material in regions of the device where an electric field is or can be generated. The material having a dielectric constant greater than 1 may thus be considered as part of the device. This material is preferably a constituting element in the form of a solid piece or block of material which can controllably be moved.

The device can include means for automatically compensating for temperature changes, e.g. by using a bimetallic element which is associated with the means for altering an internal impedance.

In the following description components for driving the FBAR are not described.

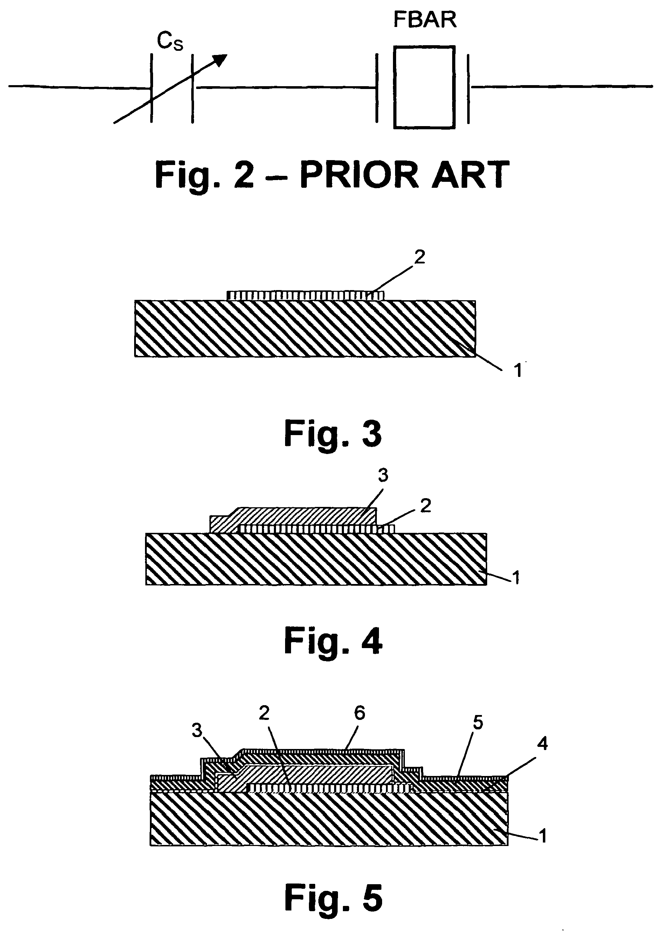

In a first embodiment, processing of a tuneable FBAR device 20 according to the present invention is described. Different methods, techniques and sequences may be used for processing a device 20 according to the invention. An example is described hereinafter. A possible sequence of process steps in the manufacture of the device 20 according to the invention is illustrated in Fig. 3-9. It has to be noted that this sequence is not limiting to the invention and that other sequences of process steps may be used to manufacture the device 20 of this invention.

First, a substrate 1 is provided. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. a high-resistivity silicon, a doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a $SiO_2$ or an $Si_3N_4$ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer.

In a next step a first conductive layer is deposited on top of the substrate 1. The first conductive layer may for example be a metal layer (e.g. copper, gold), an inorganic conductive layer (e.g. indium tin oxide (ITO)), a conductive polymer layer (polyaniline doped with camphor sulfonic acid (PANI/CSA)) or any other suitable conductive layer. The first conductive layer may be patterned by for example photolithography to form a firstelectrode 2, e.g. bottom electrode (see Fig. 3). The photolithography process comprises the following subsequent steps. First, a photoresist layer is applied on top of the first conductive layer on the substrate 1, e.g. by means of spincoating. The photoresist layer may for example have a thickness of a few $\mu$m and may be made of any suitable polymer that can be used as a photoresist, such as for example poly(vinyl cinnamate) or novolak-based polymers. Thereafter, a mask is applied to align a pattern onto the substrate 1. The photoresist layer is then illuminated through the mask e.g. by means of UV light. After illumination the photoresist is developed by which either the illuminated parts of the photoresist (positive resist) or the non-illuminated parts of the photoresist (negative resist) are removed, depending on which type of photoresist has been used. Patterning of the first conductive layer is then performed using the developed photoresist layer as a mask, after which the remaining parts of the photoresist layer are removed, typically by using an organic solvent.

Subsequent, a sacrificial layer 3 is deposited on top of the substrate 1 and the first electrode 2, e.g. bottom electrode. The sacrificial layer 3 may be any suitable material that may be used as a sacrificial material such as for example a photoresist, $SiO_2$ or polyimide. The thickness of the sacrificial layer 3 will later determine the height of the airgap (see further) in the final device 20 and typically may be up to several $\mu$m and typically may be 500 nm.. The sacrificial layer 3 may then be patterned by for example photolithography. The result after patterning is illustrated in Fig. 4.

Next, an etch stop layer 4, a piezoelectric layer 5 and a second conductive layer 6 may be deposited (Fig. 5). The piezoelectric material of layer 5 may be any piezoelectric material permitted by processing technology, such as for example aluminium nitride (AIN). AIN may be grown on a seed layer such as for example Al or Pt, or any other suitable seed layer. The second conductive layer 6, which will after patterning result in a second electrode 7, e.g. top electrode 7, may be a metal layer (e.g. copper, gold), an inorganic conductive layer (e.g. indium tin oxide (ITO)), a conductive polymer layer (polyaniline doped with camphor sulfonic acid (PANI/CSA)) or any other suitable conductive layer. The second conductive layer 6, and hence the second electrode 7, top electrode 7, may either be formed of the same or of a different material as the material of the first electrode 2, e.g. bottom electrode.

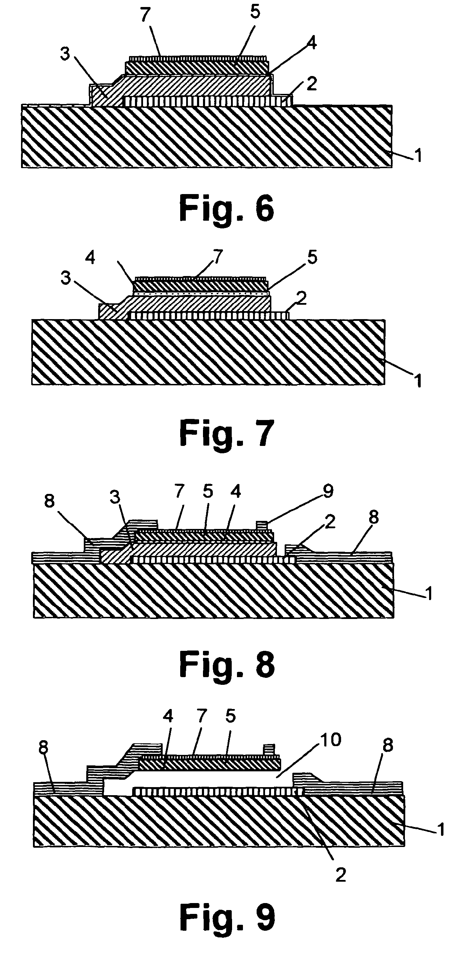

The piezoelectric layer 5 and the second conductive layer 6 may then be patterned by for example photolithography (Fig. 6). The etch stop layer 4 may prevent etching of the sacrificial layer 3 by the solvents used during patterning of the piezoelectric layer 5. However, if the solvents used during patterning of the piezoelectric layer 5 are such that they do not affect the sacrificial layer 3, no etch stop layer 4 is necessary. Thus, depending on the solvents used during patterning, deposition of an etch stop layer 4 may be optional.

In a further step, the etch stop layer 4 may be removed (see Fig. 7). This may be done by for example selective etching. In a specific example, the etch stop layer 4 may be formed out of copper, while the electrodes are for example made of Ta, ti or others. The etch stop layer 4 may then be removed by a selective etching solution that will only etch the copper layer and not the Ta or Ti layer.

Next, a third conductive layer may be deposited. Deposition of this layer may be done by any suitable technique such as for example chemical vapour deposition (CVD) or others. The third conductive layer preferably may be a metal layer such as for example copper or aluminium, but may also be any other suitable conductive layer. The third conductive layer may then be patterned as to form signal lines 8 (Fig. 8).

In a further optional step, a restraining bridge 9 may be formed (Fig. 8). This may be done by deposition and subsequent patterning of for example an Al layer. The restraining bridge 9 may be used for mechanical support and/or stability reasons of the structure of the device (20).

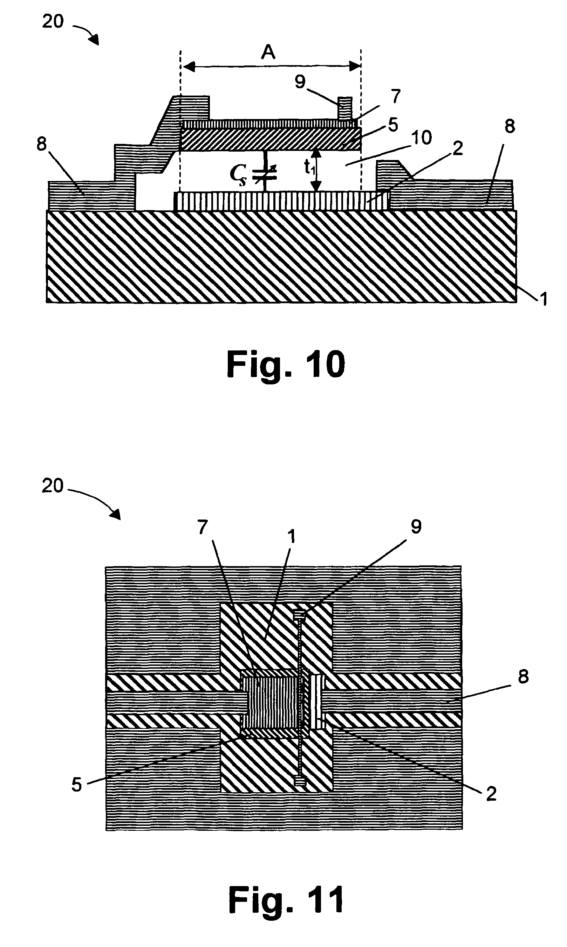

In a last step, the sacrificial layer 3 may be etched by means of for example selective etching. For example, an oxygen plasma may be used to etch a photoresist sacrificial layer or a vapour HF etch may be used to etch a $SiO_2$ sacrificial layer. Etching of the sacrificial layer 3 is necessary to create an airgap 10 between the first electrode 2, e.g. bottom electrode 2 and the piezoelectric layer 5. In that way the FBAR structure is released. As already discussed, the height of the airgap 10 may be determined by the thickness of the sacrificial layer 3 and may for example be up to several $\mu$m, and typically may be 500 nm. Optionally, the airgap 10 may be filled with a gas other than air or may be placed under vacuum. Independently of whether the gap is filled with a gas or not the layer will be referred to in the text and attached claims as a dielectric layer. In the following the terms top and bottom electrode, instead of first and second electrode will be used for ease of understanding. The device 20 according to this first embodiment of the invention is shown in Fig. 10 (side view) and Fig. 11 (top view). As can be seen from Fig. 10, a cantilever structure is formed by the piezoelectric layer 5, the top electrode 7, the optionally restraining bridge 9 and the signal line 8. In this first embodiment, actuation or tuning of the resonance frequency may be performed by changing a dimension of the device, in particular changing the height of the airgap 10 spacing $t_1$. This also provides tuning by changing the relative position of components of the device. This may be done by a vertical movement of the cantilever structure, i.e. movement of the cantilever structure in a direction substantially perpendicular to the plane of the bottom electrode 2. This vertical movement may be achieved by different actuation mechanisms layer known to the skilled person and are for instance electrothermal, electromagnetic, electrodynamic, electrostatic, piezoelectric, shape memory and magneto-restrictive actuation. Particularly, electrostatic movement of the piezoelectric cantilever is preferred. Actuators are described for instance in "The Mechatronics Handbook", CRC Press, 2002, for example chapter 20, especially section 20.5.

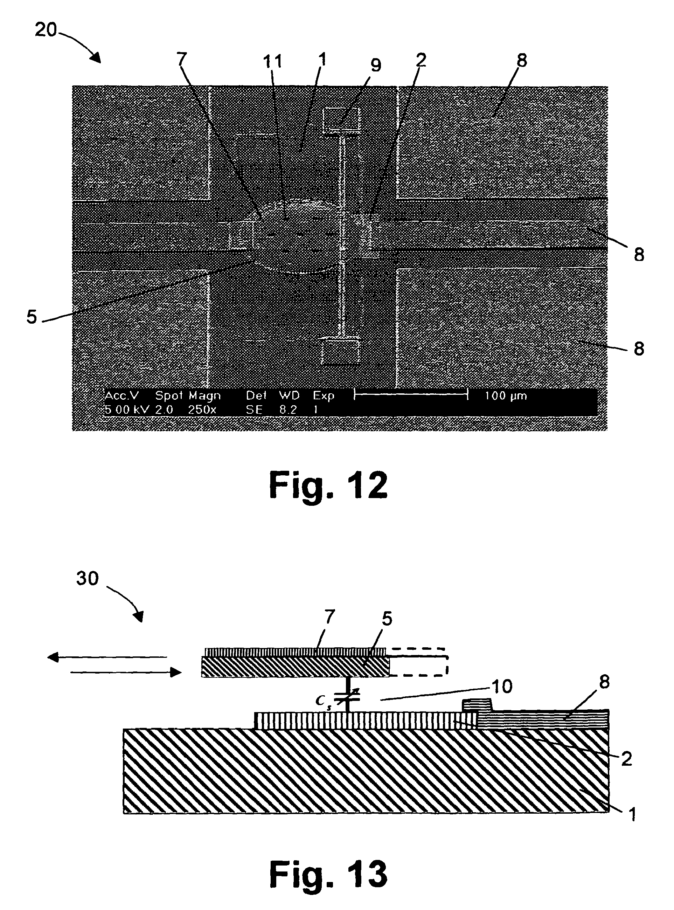

Fig. 12 shows a SEM image of an FBAR device 20 according to this first embodiment of the present invention. On the FBAR plate, which comprises the piezoelectric layer 5 and the top electrode 7, holes 11 are formed which are intended to facilitate the release of the sacrificial layer 3.

In a specific embodiment of the invention, the material of the bottom electrode 2 may comprise a first metal and the top electrode 7 may comprise a second metal, the first and second metal being different from each other and being chosen such that there may be an automatic compensation for temperature dependency.

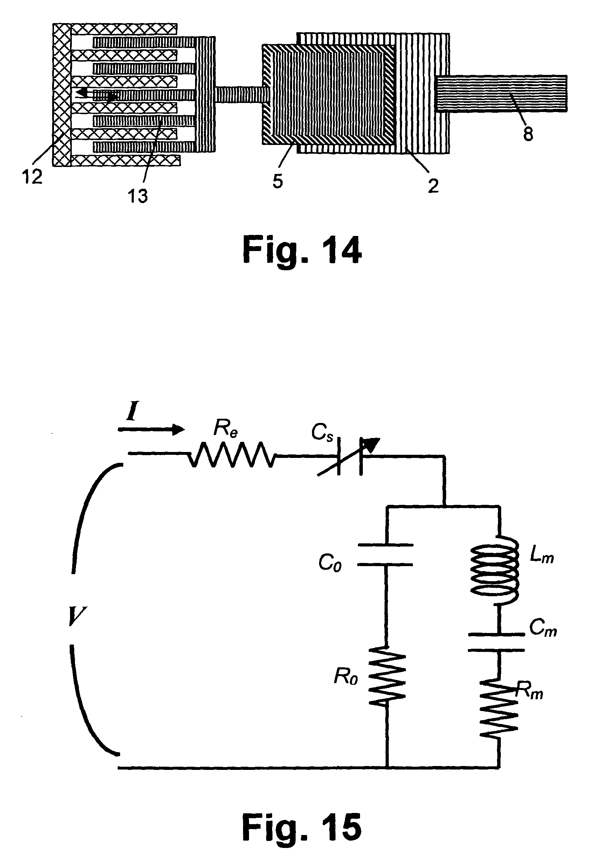

Fig. 13 (side view) and Fig. 14 (top view) illustrate a tunable FBAR device 30 according to a second embodiment of the present invention. In this embodiment, tuning of the resonance frequency is performed by changing the overlap area A, which is the overlap between the bottom electrode 2 and the piezoelectric layer 5, the overlap area A being defined by projection of the piezoelectric layer 5 onto the bottom electrode 2 according to a direction substantially perpendicular to the plane of the bottom electrode 2. This may be achieved by horizontal movement of the cantilever structure, i.e. movement of the cantilever structure in a direction substantially parallel to the plane of the bottom electrode 2. The device 30 of this invention may be comparable to the device 20 of the first embodiment, furthermore comprising a fixed comb 12 and a laterally movable comb 13, electrostatically interacting and generating a lateral movement of the piezoelectric layer 5, hereby reducing the overlap area A. Hence, the piezoelectric layer 5 is the layer which determines the area of the tuning capacitor. Different actuation mechanisms may be used in order to move elements of the FBAR. These are state of the art and are for instance electrothermal, electromagnetic, electrodynamic, electrostatic, piezoelectric, shape memory and magneto-restrictive actuation.

In Fig. 15 an equivalent electronic scheme is given for a device 20, 30 according to the present invention. In this figure, the electrical equivalents of the acoustic (resonating) part of the FBAR are represented by $L_m$, $C_m$, $R_m$. This part would determine the series resonant frequency of the circuit, if no tuning would be applied. $C_0$ represents the capacitance of the piezoelectric layer 5, $R_0$ the electrical loss in the piezoelectric layer 5, $C_s$ the tuning element, and $R_e$ the electrical resistance (parasitics, etc) in the circuit. The tuning element may be described as :

$$C_s = cst.\frac{A}{t_i} \qquad (1)$$

When an actuating force is applied to the cantilever structure, the cantilever structure with piezoelectric layer 5 moves in a vertical (first embodiment) or a horizontal (second embodiment) direction, i.e. in a direction substantially perpendicular resp. parallel to the plane of the bottom electrode 2.

The resonance frequency $\omega_r$ of the device 20, 30 according to the invention may be given by :

$$\omega_r = \sqrt{1 + \frac{C_m}{C_s + C_0}}\,\omega_0 \qquad\qquad (2)$$

wherein $w_0$ is the resonance frequency of the piezoelectric structure if no tuning or actuation exists.

$$\omega_0 = \frac{1}{\sqrt{L_m C_m}} \qquad\qquad (3)$$

By moving the cantilever structure, the capacitance of the air-gap $C_s$ changes and, according to equation (2), the resonance frequency of the device 20, 30 also changes.

Tuning via electric-field stress or electromechanical stress would only render a very small shift in frequency. Thermal tuning requires large power consumption and is difficult to fabricate. The conventional electrical tuning method would introduce extra loss and parasitic effects because of a separate element added. The design according to the present invention makes the tuning element an integrated part of the device 20, 30, thereby not only serving as the tuning element, but also as acoustic isolation and is expected to improve the overall quality factor by at least an order of magnitude. The Q factor is determined by the material properties and the parasitics. The Q factor of a resonant device may be defined by:

$$Q = 2\pi \left( \frac{\text{maximum energy stored}}{\text{energy loss per cycle}} \right)$$

Since the energy loss per cycle is equal to the (average power dissipated) times (periodic time) and

$$Q = 2\pi\, f_r \left( \frac{\text{maximum energy stored}}{\text{average power dissipated}} \right)$$

Where $f_r$ is the resonant frequency.

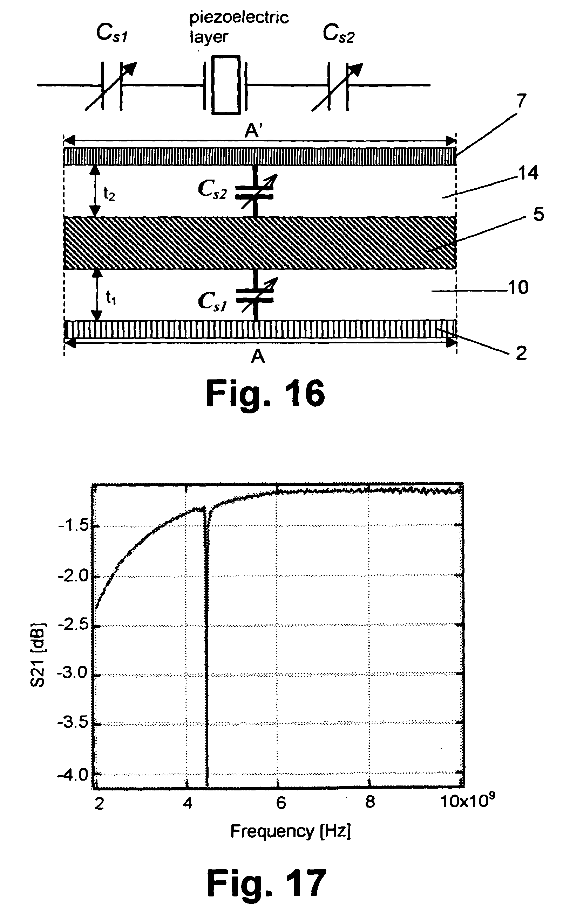

In a third embodiment according to the present invention, a device is disclosed with a structure wherein the piezoelectric layer 5 is not in contact with any of the electrodes 2, 7. This is illustrated in Fig. 16. The device of this embodiment may be called a dual gap device, because as can be seen from Fig. 16, the piezoelectric layer 5 is not in contact with any of the electrodes 2, 7 and a gap 10, 14 is formed between the bottom electrode 2 and the piezoelectric layer 5 (thickness $t_1$) resp. between the top electrode 7 and the piezoelectric layer 5 (thickness $t_2$). Since there is no electrode 2, 7 in the acoustic path of the FBAR 40, it is possible to reach a very high Q factor. The value of the Q factor is mainly limited by the material loss of the piezoelectric layer 5, (Joel F. Rosenbaum "Bulk Acoustic Wave Theory and Devices", Artech House, 1988, ISBN 0-89006-265-X).

In this embodiment, the piezoelectric layer 5 may have an overlap A with the bottom electrode 2 and may have an overlap A' with the top electrode 7, the overlap A and A' being defined as the projection of the piezoelectric layer 5 onto the bottom electrode 2 resp. top electrode 7 in a direction substantially perpendicular to the plane of the bottom electrode 2 resp. top electrode 7. The frequency may be tuned by moving either one or both of the electrodes 2, 7 or the piezoelectric layer 5 itself in a vertical and/or horizontal direction, resp. defined as the direction substantially perpendicular and/or parallel to the plane of the bottom electrode 2. In that way, the overlap A and/or overlap A' and/or the thicknesses of the air gaps 10, 14, or more in general, the thicknesses $t_1$, $t_2$ of the dielectric layers 10, 14, may be changed in order to achieve tuning. By only moving the piezoelectric layer 5 in a horizontal or vertical direction, both airgaps 10, 14 may be varied. Moving the piezoelectric layer is an embodiment of the present invention in which a material with a dielectric constant greater than 1 is moved in or out of a part of the device where there is an electric field.

The equivalent tuning capacitor may be given by :

$$C_S = \frac{C_{S1}C_{S2}}{C_{S1} + C_{S2}} \tag{4}$$

According to the present invention, the frequency tuning device or element is integrated into the FBAR instead of being implemented as a discrete external component. Furthermore, the tuning element may function as an acoustic isolation. This design of the device according to the present invention enables a high quality factor. The Q factor may preferably be higher than a few hundred and more preferably more higher than a few thousand. This is mainly due to the elimination of the contact between bottom electrode 2 and the piezoelectric layer 5 in a conventional sandwiched structure, the elimination of interconnections in the case of a discretely-coupled conventional approach, and the possibility of eliminating the piezoelectric layer 5-contacting electrodes in total.

The airgap 10 tuning of the device 20, 30 may be performed by state-of-the art actuation methods as described before. Furthermore, the method according to the present invention is reversible. This means that tuning of the resonance frequency is not permanent. The resonance frequency may be tuned towards higher and lower frequencies.

The present invention allows a lower power consumption compared with thermal tuning and offers real-time tunability. Furthermore, the device 20, 30 of the present invention allow a relative compensation of between 1 and 3%, whereas in the prior art only relative compensation of 0.1 % may be achieved.

The embodiments according to the present invention may be produced with state-of-the-art surface micromachining techniques.

Another tuning possibility of the first or third embodiment of the present invention may be post-pull-in tuning. This may be done when part of the movable structure is in its post-pull-in state and is touching the substrate. When the pull-in state is reached, it may still be possible to change the frequency if only part of the piezoelectric cantilever is touching the bottom electrode 2, but the change is really hard to precisely predicate.

The device according to the first and third embodiment of the present invention may function as a switchable FBAR (from ante- to post-pull-in), i.e. the resonant frequency of the device may have a sharp transition before and after pull-in happens.

A further embodiment of the present invention relates to an embodiment of the present invention in which a material with a dielectric constant greater than 1 is moved in or out of a part of the device where there is an electric field. This material is preferably a constituting element in the form of a solid piece or block of material which can controllably be moved. The material may be considered as part of device. In this embodiment a material is moved in or out of either or both of the spaces 10 or 14. This material has a dielectric constant greater than 1 and therefore influences the capacitance $Cs_1$ and/or $Cs_2$ to thereby tune the resonance frequency. Different actuation mechanisms may be used in order to move elements of the FBAR. These are state of the art and are for instance electrothermal, electromagnetic, electrodynamic, electrostatic, piezoelectric, shape memory and magneto-restrictive actuation.

The FBAR device in accordance with any of the embodiments of the present invention can include means for automatically compensating for temperature changes, e.g. by using a bimetallic element which is associated with the means for altering an internal impedance. The piezoelectric layer and the top electrode can differ in thermal expansion coefficients. This may result in the top electrode moving closer to or further away from the bottom electrode as the temperature changes. This effect may be used to compensate for changes in the resonant frequency with temperature. To assist in this compensation the top electrode may be made of two differing metals which therefore act as a bi-metallic strip. Changes in temperature will cause the bi-metallic strip which forms the top electrode to move up or down with respect to the bottom electrode and careful choice of materials and thickness can be used to compensate for any changes in resonance frequency cause by changes in temperature.

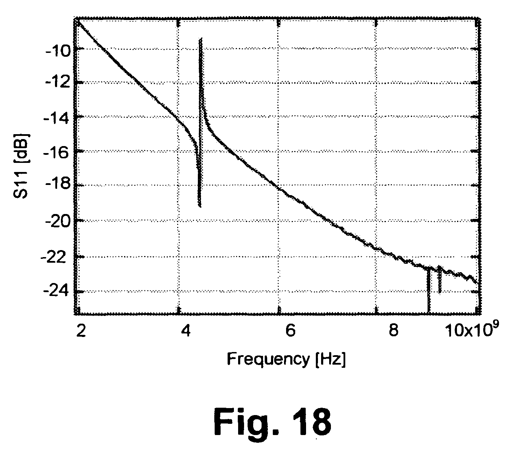

Fig. 17 show measured $S_{21}$ value with respect to signal frequencies for a device as described in the first embodiment of this invention. Fig. 18 show measured $S_{11}$ value with respect to signal frequencies for the corresponding (Fig. 17 respectively) for the same specific embodiment according to the present invention. The $S_{11}$ parameter is a measure of the reflection coefficient of a component, while the $S_{21}$ parameter is a measure of the transmission coefficient of that component. S parameters are a representation of the properties of a network. The S21 and S11 parameters are often used to describe the transmission and reflection of a certain two-port network.

It is an advantage of several embodiments of the present invention that horizontal movements of the components of the device, i.e. movements parallel with the plane of the bottom electrode, allow to tune the resonance frequency of the device

It is to be understood that although preferred embodiments, specific constructions and configurations, as well as materials, have been discussed herein for devices according to the present invention, various changes or modifications in form and detail may be made without departing from the scope of this invention as defined in the appended claims.

**Claims**

1. An *resonance frequency tuneable* FBAR device (20, 30) comprising:

   - a bottom electrode (2) and a top electrode (7),
   - a piezoelectric layer (5) in between said bottom electrode (2) and said top electrode (7), the piezoelectric layer (5) having a first overlap with the bottom electrode (2), said first overlap being defined as the projection of the piezoelectric layer (5) onto the bottom electrode (2) in a direction substantially perpendicular to the plane of the bottom electrode (2), *thus determining a tuning capacitor,* and
   - a dielectric layer (10) in between the piezoelectric layer (5) and the bottom electrode (2), said dielectric layer (10) having a first thickness $t_1$ and comprising any of air, gas or vacuum, and
   - a means *for changing the capacitance of the tuning capacitor,* for reversibly varying an internal impedance of the device (20, 30) to thereby tune the resonance frequency of the device.

2. An FBAR device (20,30) according to the previous claim, wherein said means for reversibly varying an internal impedance comprises a means for altering a relative position of components of the device.

3. An FBAR device (20,30) according to claim 2 wherein said means for altering a relative position is a means for altering the position of any of said top electrode, said bottom electrode, said piezoelectric layer or a material having a dielectric constant greater than 1 and adapted for shifting into or out of a part of the device in which an electric field can be generated.

4. An FBAR device according to claim 3, wherein said material having a dielectric constant greater than 1 is a constituting element in the form of a solid piece or block of material which can controllably be moved.

5. An FBAR device (20,30) according to any of claims 2 to 4, wherein said means for altering a relative position of components of the device is a means for shifting said components substantially parallel with said plane of said bottom electrode (2).

6. An FBAR device (20, 30) according to any of the previous claims, wherein said piezoelectric layer is suspended on one side only and is part of a cantilever structure.

7. An FBAR device (20,30) according to any of the previous claims, wherein the means for varying an internal impedance of the device (20, 30) is a means for varying the first thickness $t_1$ of the dielectric layer (10).

8. An FBAR device (20, 30) according to any of the previous claims, the device furthermore comprising a further dielectric layer (14), having a second thickness $t_2$, in between the piezoelectric layer (5) and the top electrode (7), the piezoelectric layer (5) having a second overlap with the top electrode (7), said second overlap being defined as the projection of the piezoelectric layer (5) onto the top electrode (7) in a direction substantially perpendicular to the plane of the top electrode (7).

9. An FBAR device according to claim 8, wherein the means for varying an internal impedance of the device (20, 30) is a means for varying the second thickness $t_2$.

10. An FBAR device (20, 30) according to any of claims 1 to 9, wherein the bottom electrode (2) comprises a first material and the top electrode (7) comprises a second material, the first material and the second material being different from each other.

11. An FBAR device (20, 30) according to claim 10, wherein the first material is a first metal and the second material is a second metal, the first and second metal being different from each other.

12. An FBAR device (20, 30) according to any of the previous claims, the device (20, 30) having a Q factor higher than a few hundred, preferably higher than a few thousand.

13. An FBAR device (20, 30) according to any of the previous claims, the device (20, 30) having a relative tuning range of between 1 and 3%.

14. An *resonance frequency tuneable* FBAR device (20, 30) consisting of:

- a bottom electrode (2) and a top electrode (7),
- a piezoelectric layer (5) in between said bottom electrode (2) and said top electrode (7), the piezoelectric layer (5) having a first overlap with the bottom electrode (2), said first overlap being defined as the projection of the piezoelectric layer (5) onto the bottom electrode (2) in a direction substantially perpendicular to the plane of the bottom electrode (2) *thus determining a tuning capacitor,* and
- a dielectric layer (10) in between the piezoelectric layer (5) and the bottom electrode (2), said dielectric layer (10) having a first thickness $t_1$ and comprising any of air, gas or vacuum, and
- a means *for changing the capacitance of the tuning capacitor,* for reversibly varying an internal impedance of the device (20, 30) to thereby tune the resonance frequency of the device.

15. An FBAR device according to claim 14, wherein said piezoelectric layer is suspended on one side only and is part of a cantilever structure.

16. An FBAR device according to claim 14 to 15, wherein the means for varying an internal impedance of the device is a means for altering a relative position of components of the device.

17. An FBAR device according to claim 16, wherein altering a relative position comprises moving a constituting element in the form of a solid piece or block of material having a dielectric constant greater than 1 into or out of a part of the device in which an electric field can be generated.

18. An FBAR device (20,30) according to any of claims 14 to 17, wherein the means for varying an internal impedance of the device (20, 30) is a means for varying the first thickness $t_1$ of the dielectric layer (10).

19. A method for internally tuning the resonance frequency of an FBAR device (20, 30), said FBAR device (20, 30) comprising:

- a bottom electrode (2) and a top electrode (7),
- a piezoelectric layer (5) in between said bottom electrode (2) and said top electrode (7), the piezoelectric layer (5) having a first overlap with the bottom electrode (2), said first overlap being defined as the projection of the piezoelectric layer (5) onto the bottom electrode (2) in a direction substantially perpendicular to the plane of the bottom electrode (2) *thus determining a tuning capacitor,* and
- a dielectric layer (10) in between the piezoelectric layer (5) and the bottom electrode (2) the dielectric layer comprising any of air, gas or vacuum, wherein said internally tuning is reversibly internally tuning the resonance frequency by varying an internal impedance of the device by adjusting the dielectric layer comprising any of air, gas or vacuum.

20. A method according to claim 19, wherein said reversibly internally tuning comprises altering a relative position of components of the device.

21. A method according to any of claims 19 to 20, wherein said altering a relative position of components of the device comprises altering a relative position of any of a bottom electrode, a top electrode, a piezoelectric layer or a material having a dielectric constant greater than 1, adapted for shifting into or out of a part of the device in which an electric field can be generated.

22. A method according to any of claims 19 to 21, wherein said piezoelectric layer is suspended on one side only and is part of a cantilever structure.

23. A method according to claim 19 to 22, wherein the dielectric layer (10) has a first thickness $t_1$, and said resonance frequency is tuned by varying said first overlap and/or varying said first thickness $t_1$.

24. A method according to claim 23, whereby varying said first overlap is performed by moving the piezoelectric layer (5) in a horizontal direction with respect to the bottom electrode (2), i.e. in a direction substantially parallel with the plane of the bottom electrode (2).

25. A method according to claim 23, whereby varying said first thickness $t_1$ is performed by moving the top electrode (7) in a vertical direction with respect to the bottom electrode (2), in a direction substantially perpendicular to the plane of the bottom electrode (2).

**26.** A method according to any of claims 19 to 25, the FBAR device furthermore comprising a dielectric layer (14) with a second thickness $t_2$ in between the piezoelectric layer (5) and the top electrode (7), the piezoelectric layer (5) having a second overlap with the top electrode (7), said second overlap being defined as the projection of the piezoelectric layer (5) onto the top electrode (7) in a direction substantially perpendicular to the plane of the top electrode (7),

the method furthermore comprising tuning said resonance frequency by varying said second overlap and/or said thickness $t_2$.

**Patentansprüche**

**1.** In der Resonanzfrequenz abstimmbare FBAR-Vorrichtung (20, 30), umfassend:

- eine untere Elektrode (2) und eine obere Elektrode (7);
- eine piezoelektrische Schicht (5) zwischen der unteren Elektrode (2) und der oberen Elektrode (7), wobei die piezoelektrische Schicht (5) eine erste Überlappung mit der unteren Elektrode (2) hat, wobei die erste Überlappung als der Fortsatz der piezoelektrischen Schicht (5) auf die untere Elektrode (2) in eine Richtung im Wesentlichen senkrecht zur Ebene der unteren Elektrode (2) definiert ist, wodurch ein Abstimmkondensator bestimmt wird, und
- eine dielektrische Schicht (10) zwischen der piezoelektrischen Schicht (5) und der unteren Elektrode (2), wobei die dielektrische Schicht (10) eine erste Dicke $t_1$ hat und eines von Luft, Gas oder Vakuum umfasst, und
- ein Mittel zum Ändern der Kapazität des Abstimmkondensators, um eine innere Impedanz der Vorrichtung (20, 30) reversibel zu variieren, um **dadurch** die Resonanzfrequenz der Vorrichtung abzustimmen.

**2.** FBAR-Vorrichtung (20, 30) nach dem vorangehenden Anspruch, wobei das Mittel zum reversiblen Variieren einer inneren Impedanz ein Mittel zum Ändern einer relativen Position von Komponenten der Vorrichtung umfasst.

**3.** FBAR-Vorrichtung (20, 30) nach Anspruch 2, wobei das Mittel zum Ändern einer relativen Position ein Mittel zum Ändern der Position eines von der oberen Elektrode, der unteren Elektrode, der piezoelektrischen Schicht oder eines Materials mit einer dielektrischen Konstante von mehr als 1 ist und dazu ausgebildet ist in einen oder aus einem Teil der Vorrichtung geschoben zu werden, in dem ein elektrisches Feld erzeugt werden kann.

**4.** FBAR-Vorrichtung (20, 30) nach Anspruch 3, wobei das Material mit einer dielektrischen Konstante von mehr als 1 ein Bestandteil in der Form eines festen Stücks oder Materialblocks ist, das kontrollierbar bewegt werden kann.

**5.** FBAR-Vorrichtung (20, 30) nach einem der Ansprüche 2 bis 4, wobei das Mittel zum Ändern einer relativen Position von Komponenten der Vorrichtung ein Mittel zum Verschieben der Komponenten im Wesentlichen parallel zu der Ebene der unteren Elektrode (2) ist.

**6.** FBAR-Vorrichtung (20, 30) nach einem der vorangehenden Ansprüche, wobei die piezoelektrische Schicht an nur einer Seite hängt und Teil einer Auslegerstruktur ist.

**7.** FBAR-Vorrichtung (20, 30) nach einem der vorangehenden Ansprüche, wobei das Mittel zum Variieren einer inneren Impedanz der Vorrichtung (20, 30) ein Mittel zum Variieren der ersten Dicke $t_1$ der dielektrischen Schicht (10) ist.

**8.** FBAR-Vorrichtung (20, 30) nach einem der vorangehenden Ansprüche, wobei die Vorrichtung des Weiteren eine weitere dielektrische Schicht (14) mit einer zweiten Dicke $t_2$ zwischen der piezoelektrischen Schicht (5) und der oberen Elektrode (7) umfasst, wobei die piezoelektrische Schicht (5) eine zweite Überlappung mit der oberen Elektrode (7) hat, wobei die zweite Überlappung als der Fortsatz der piezoelektrischen Schicht (5) auf die obere Elektrode (7) in eine Richtung im Wesentlichen senkrecht zur Ebene der oberen Elektrode (7) definiert ist.

**9.** FBAR-Vorrichtung (20, 30) nach Anspruch 8, wobei das das Mittel zum Variieren einer inneren Impedanz der Vorrichtung (20, 30) ein Mittel zum Variieren der zweiten Dicke $t_2$ ist.

**10.** FBAR-Vorrichtung (20, 30) nach einem der Ansprüche 1 bis 9, wobei die untere Elektrode (2) ein erstes Material umfasst und die obere Elektrode (7) ein zweites Material umfasst, wobei sich das erste Material und das zweite Material voneinander unterscheiden.

**11.** FBAR-Vorrichtung (20, 30) nach Anspruch 10, wobei das erste Material ein erstes Metall ist und das zweite Material ein zweites Metall ist, wobei sich das erste und das zweite Metall voneinander unterscheiden.

**12.** FBAR-Vorrichtung (20, 30) nach einem der vorangehenden Ansprüche, wobei die Vorrichtung (20, 30) einen Q-Faktor hat, der höher als einige Hundert ist, vorzugsweise höher als einige Tausend ist.

**13.** FBAR-Vorrichtung (20, 30) nach einem der vorangehenden Ansprüche, wobei die Vorrichtung (20, 30) einen relativen Abstimmbereich zwischen 1 und 3% hat.

**14.** In der Resonanzfrequenz abstimmbare FBAR-Vorrichtung (20, 30), bestehend aus:

- einer unteren Elektrode (2) und einer oberen Elektrode (7) ;
- einer piezoelektrischen Schicht (5) zwischen der unteren Elektrode (2) und der oberen Elektrode (7), wobei die piezoelektrische Schicht (5) eine erste Überlappung mit der unteren Elektrode (2) hat, wobei die erste Überlappung als der Fortsatz der piezoelektrischen Schicht (5) auf die untere Elektrode (2) in eine Richtung im Wesentlichen senkrecht zur Ebene der unteren Elektrode (2) definiert ist, wodurch ein Abstimmkondensator bestimmt wird, und
- einer dielektrischen Schicht (10) zwischen der piezoelektrischen Schicht (5) und der unteren Elektrode (2), wobei die dielektrische Schicht (10) eine erste Dicke $t_1$ hat und eines von Luft, Gas oder Vakuum umfasst, und
- einem Mittel zum Ändern der Kapazität des Abstimmkondensators, um eine innere Impedanz der Vorrichtung (20, 30) reversibel zu variieren, um **dadurch** die Resonanzfrequenz der Vorrichtung abzustimmen.

**15.** FBAR-Vorrichtung (20, 30) nach Anspruch 14, wobei die piezoelektrische Schicht an nur einer Seite hängt und Teil einer Auslegerstruktur ist.

**16.** FBAR-Vorrichtung (20, 30) nach Anspruch 14 bis 15, wobei das Mittel zum Variieren einer inneren Impedanz ein Mittel zum Ändern einer relativen Position von Kompcnenten der Vorrichtung ist.

**17.** FBAR-Vorrichtung (20, 30) nach Anspruch 16, wobei das Ändern einer relativen Position das Bewegen eines Bestandteils in der Form eines festen Stücks oder Materialblocks mit einer dielektrischen Konstante von mehr als 1 in einen oder aus einem Teil der Vorrichtung, in dem ein elektrisches Feld erzeugt werden kann, umfasst.

**18.** FBAR-Vorrichtung (20, 30) nach einem der Ansprüche 14 bis 17, wobei das Mittel zum Variieren einer inneren Impedanz der Vorrichtung (20, 30) ein Mittel zum Variieren der ersten Dicke $t_1$ der dielektrischen Schicht (10) ist.

**19.** Verfahren zum internen Abstimmen der Resonanzfrequenz einer FBAR-Vorrichtung (20, 30), wobei die FBAR-Vorrichtung (20, 30) umfasst:

- eine untere Elektrode (2) und eine obere Elektrode (7);
- eine piezoelektrische Schicht (5) zwischen der unteren Elektrode (2) und der oberen Elektrode (7), wobei die piezoelektrische Schicht (5) eine erste Überlappung mit der unteren Elektrode (2) hat, wobei die erste Überlappung als der Fortsatz der piezoelektrischen Schicht (5) auf die untere Elektrode (2) in eine Richtung im Wesentlichen senkrecht zur Ebene der unteren Elektrode (2) definiert ist, wodurch ein Abstimmkondensator bestimmt wird, und
- eine dielektrische Schicht (10) zwischen der piezoelektrischen Schicht (5) und der unteren Elektrode (2), wobei die dielektrische Schicht (10) eines von Luft, Gas oder Vakuum umfasst, wobei die interne Abstimmung eine reversible interne Abstimmung der Resonanzfrequenz durch Variieren einer inneren Impedanz der Vorrichtung durch Einstellen der dielektrischen Schicht ist, die eines von Luft, Gas oder Vakuum umfasst.

**20.** Verfahren nach Anspruch 19, wobei das reversible interne Abstimmen das Ändern einer relativen Position von Komponenten der Vorrichtung umfasst.

**21.** Verfahren nach einem der Ansprüche 19 bis 20, wobei das Ändern einer relativen Position von Komponenten der Vorrichtung das Ändern einer relativen Position eines von einer unteren Elektrode, einer oberen Elektrode, einer piezoelektrischen Schicht oder eines Materials mit einer dielektrischen Konstante von mehr als 1 umfasst, die dazu ausgebildet ist in einen oder aus einem Teil der Vorrichtung geschoben zu werden, in dem ein elektrisches Feld erzeugt werden kann.

**22.** Verfahren nach einem der Ansprüche 19 bis 21, wobei die piezoelektrische Schicht an nur einer Seite hängt und Teil einer Auslegerstruktur ist.

**23.** Verfahren nach einem der Ansprüche 19 bis 22, wobei die dielektrische Schicht (10) eine erste Dicke $t_1$ hat, und die Resonanzfrequenz durch Variieren der ersten Überlappung und/oder Variieren der ersten Dicke $t_1$ abgestimmt wird.

**24.** Verfahren nach Anspruch 23, wobei das Variieren der ersten Überlappung durch Bewegen der piezoelektrischen Schicht (5) in eine horizontale Richtung in Bezug auf die untere Elektrode (2) durchgeführt wird, d.h., in eine Richtung im Wesentlichen parallel zur Ebene der unteren Elektrode (2).

**25.** Verfahren nach einem der Ansprüche 23, wobei das Variieren der ersten Dicke $t_1$ durch Bewegen der oberen Elektrode (7) in eine vertikale Richtung in Bezug auf die untere Elektrode (2) durchgeführt wird, d.h., in eine Richtung im Wesentlichen senkrecht zur Ebene der unteren Elektrode (2).

**26.** Verfahren nach einem der Ansprüche 19 bis 25, wobei die FBAR-Vorrichtung des Weiteren eine dielektrische Schicht (14) mit einer zweiten Dicke $t_2$ zwischen der piezoelektrischen Schicht (5) und der oberen Elektrode (7) umfasst, wobei die piezoelektrische Schicht (5) eine zweite Überlappung mit der oberen Elektrode (7) hat, wobei die zweite Überlappung als der Fortsatz der piezoelektrischen Schicht (5) auf die obere Elektrode (7) in eine Richtung im Wesentlichen senkrecht zur Ebene der oberen Elektrode (7) definiert ist,
wobei das Verfahren des Weiteren das Abstimmen der Resonanzfrequenz durch Variieren der zweiten Überlappung und/oder der Dicke $t_2$ umfasst.

**Revendications**

**1.** Dispositif FBAR à fréquence de résonance pouvant être accordée (20, 30) comprenant :

- une électrode inférieure (2) et une électrode supérieure (7),
- une couche piézo-électrique (5) entre ladite électrode inférieure (2) et ladite électrode supérieure (7), la couche piézo-électrique (5) ayant un premier chevauchement avec l'électrode inférieure (2), ledit premier chevauchement étant défini comme la projection de la couche piézo-électrique (5) sur l'électrode inférieure (2) dans une direction sensiblement perpendiculaire au plan de l'électrode inférieure (2), déterminant ainsi un condensateur de réglage d'accord, et
- une couche diélectrique (10) entre la couche piézo-électrique (5) et l'électrode inférieure (2), ladite couche diélectrique (10) ayant une première épaisseur $t_1$ et comprenant n'importe lequel d'air, de gaz ou de vide, et
- un moyen pour changer la capacité du condensateur de réglage d'accord, pour faire varier de manière réversible une impédance interne du dispositif (20, 30) pour accorder de ce fait la fréquence de résonance du dispositif.

**2.** Dispositif FBAR (20, 30) selon la revendication précédente, dans lequel ledit moyen pour faire varier de manière réversible une impédance interne comprend un moyen pour modifier une position relative des composants du dispositif.

**3.** Dispositif FBAR (20, 30) selon la revendication 2, dans lequel ledit moyen pour modifier une position relative est un moyen pour modifier la position de n'importe laquelle de ladite électrode supérieure, de ladite électrode inférieure, de ladite couche piézo-électrique ou d'une matière ayant une constante diélectrique plus grande que 1 et est conçu pour décaler en dedans ou en dehors une partie du dispositif dans laquelle un champ électrique peut être produit.

**4.** Dispositif FBAR selon la revendication 3, dans lequel ladite matière ayant une constante diélectrique plus grande que 1 est un élément constituant sous la forme d'une pièce ou d'un bloc solide de matière qui peut être déplacé de manière commandée.

**5.** Dispositif FBAR (20, 30) selon l'une quelconque des revendications 2 à 4, dans lequel ledit moyen pour modifier une position relative de composants du dispositif est un moyen pour décaler lesdits composants sensiblement parallèlement audit plan de ladite électrode inférieure (2).

**6.** Dispositif FBAR (20, 30) selon l'une quelconque des revendications précédentes, dans lequel ladite couche piézo-électrique est suspendue sur un côté seulement et fait partie d'une structure de cantilever.

**7.** Dispositif FBAR (20, 30) selon l'une quelconque des revendications précédentes, dans lequel le moyen pour faire varier une impédance interne du dispositif (20, 30) est un moyen pour faire varier la première épaisseur $t_1$ de la couche diélectrique (10).

**8.** Dispositif FBAR (20, 30) selon l'une quelconque des revendications précédentes, le dispositif comprenant en outre une couche diélectrique supplémentaire (14), ayant une seconde épaisseur $t_2$, entre la couche piézo-électrique (5) et l'électrode supérieure (7), la couche piézo-électrique (5) ayant un second chevauchement avec l'électrode supérieure (7), ledit second chevauchement étant défini comme la projection de la couche piézo-électrique (5) sur l'électrode supérieure (7) dans une direction sensiblement perpendiculaire au plan de l'électrode supérieure (7).

**9.** Dispositif FBAR selon la revendication 8, dans lequel le moyen pour faire varier une impédance interne du dispositif (20, 30) est un moyen pour faire varier la seconde épaisseur $t_2$.

**10.** Dispositif FBAR (20, 30) selon l'une quelconque des revendications 1 à 9, dans lequel l'électrode inférieure (2) comprend une première matière et l'électrode supérieure (7) comprend une seconde matière, la première matière et la seconde matière étant différentes l'une de l'autre.

**11.** Dispositif FBAR (20, 30) selon la revendication 10, dans lequel la première matière est un premier métal et la seconde matière est un second métal, le premier et le second métal étant différents l'un de l'autre.

**12.** Dispositif FBAR (20, 30) selon l'une quelconque des revendications précédentes, le dispositif (20, 30) ayant un facteur Q plus élevé que quelques centaines, de préférence plus élevé que quelques milliers.

**13.** Dispositif FBAR (20, 30) selon l'une quelconque des revendications précédentes, le dispositif (20, 30) ayant une plage d'accord relative entre 1 et 3 %.

**14.** Dispositif FBAR à fréquence de résonance pouvant être accordée (20, 30) consistant en :

 - une électrode inférieure (2) et une électrode supérieure (7),
 - une couche piézo-électrique (5) entre ladite électrode inférieure (2) et ladite électrode supérieure (7), la couche piézo-électrique (5) ayant un premier chevauchement avec l'électrode inférieure (2), ledit premier chevauchement étant défini comme la projection de la couche piézo-électrique (5) sur l'électrode inférieure (2) dans une direction sensiblement perpendiculaire au plan de l'électrode inférieure (2) déterminant ainsi un condensateur de réglage d'accord, et
 - une couche diélectrique (10) entre la couche piézo-électrique (5) et l'électrode inférieure (2), ladite couche diélectrique (10) ayant une première épaisseur $t_1$ et comprenant n'importe lequel d'air, de gaz ou de vice, et
 - un moyen pour changer la capacité du condensateur de réglage d'accord, pour faire varier de manière réversible une impédance interne du dispositif (20, 30) pour accorder de ce fait la fréquence de résonance du dispositif.

**15.** Dispositif FBAR selon la revendication 14, dans lequel ladite couche piézo-électrique est suspendue sur un côté seulement et fait partie d'une structure de cantilever.

**16.** Dispositif FBAR selon la revendication 14 à 15, dans lequel le moyen pour faire varier une impédance interne du dispositif est un moyen pour modifier une position relative des composants du dispositif.

**17.** Dispositif FBAR selon la revendication 16, dans lequel la modification d'une position relative comprend le déplacement d'un élément constitutif sous la forme d'une pièce ou d'un bloc solide de matière ayant une constante diélectrique plus grande que 1 en dedans ou en dehors d'une partie du dispositif dans laquelle un champ électrique peut être produit.

**18.** Dispositif FBAR (20, 30) selon l'une quelconque des revendications 14 à 17, dans lequel le moyen pour faire varier une impédance interne du dispositif (20, 30) est un moyen pour faire varier la première épaisseur $t_1$ de la couche diélectrique (10).

**19.** Procédé pour accorder en interne la fréquence de résonance d'un dispositif FBAR (20, 30), ledit dispositif FBAR (20, 30) comprenant :

 - une électrode inférieure (2) et une électrode supérieure (7),

- une couche piézo-électrique (5) entre ladite électrode inférieure (2) et ladite électrode supérieure (7), la couche piézo-électrique (5) ayant un premier chevauchement avec l'électrode inférieure (2), ledit premier chevauchement étant défini comme la projection de la couche piézo-électrique (5) sur l'électrode inférieure (2) dans une direction sensiblement perpendiculaire au plan de l'électrode inférieure (2) déterminant ainsi un condensateur de réglage d'accord, et

- une couche diélectrique (10) entre la couche piézo-électrique (5) et l'électrode inférieure (2), la couche diélectrique comprenant n'importe lequel d'air, de gaz ou de vide, dans lequel ledit réglage d'accord en interne accorde de manière réversible en interne la fréquence de résonance en faisant varier une impédance interne du dispositif en ajustant la couche diélectrique comprenant n'importe lequel d'air, de gaz ou de vide.

20. Procédé selon la revendication 19, dans lequel ledit réglage d'accord en interne de manière réversible comprend la modification d'une position relative de composants du dispositif.

21. Procédé selon l'une quelconque des revendications 19 à 20, dans lequel ladite modification d'une position relative des composants du dispositif comprend la modification d'une position relative de n'importe laquelle d'une électrode inférieure, d'une électrode supérieure, d'une couche piézo-électrique ou d'une matière ayant une constante diélectrique plus grande que 1, conçue pour décaler en dedans ou en dehors une partie du dispositif dans laquelle un champ électrique peut être produit.

22. Procédé selon l'une quelconque des revendications 19 à 21, dans lequel ladite couche piézo-électrique est suspendue sur un côté seulement et fait partie d'une structure de cantilever.

23. Procédé selon les revendications 19 à 22, dans lequel la couche diélectrique (10) a une première épaisseur $t_1$, et ladite fréquence de résonance est accordée en faisant varier ledit premier chevauchement et/ou en faisant varier ladite première épaisseur $t_1$.

24. Procédé selon la revendication 23, dans lequel la variation dudit premier chevauchement est effectuée en déplaçant la couche piézo-électrique (5) dans une direction horizontale par rapport à l'électrode inférieure (2), c'est-à-dire dans une direction sensiblement parallèle au plan de l'électrode inférieure (2).

25. Procédé selon la revendication 23, dans lequel la variation de ladite première épaisseur $t_1$ est effectuée en déplaçant l'électrode supérieure (7) dans une direction verticale par rapport à l'électrode inférieure (2), dans une direction sensiblement perpendiculaire au plan de l'électrode inférieure (2).

26. Procédé selon l'une quelconque des revendications 19 à 25, le dispositif FBAR comprenant en outre une couche diélectrique (14) ayant une seconde épaisseur $t_2$ entre la couche piézo-électrique (5) et l'électrode supérieure (7), la couche piézo-électrique (5) ayant un second chevauchement avec l'électrode supérieure (7), ledit second chevauchement étant défini comme la projection de la couche piézo-électrique (5) sur l'électrode supérieure (7) dans une direction sensiblement perpendiculaire au plan de l'électrode supérieure (7),
le procédé comprenant en outre le réglage d'accord de ladite fréquence de résonance en faisant varier ledit second chevauchement et/ou ladite épaisseur $t_2$.

(a)

(b)

(c)

(d)

**Fig. 1 – PRIOR ART**

EP 1 548 768 B1

FBAR

$C_S$

## Fig. 2 – PRIOR ART

2

1

## Fig. 3

3

2

1

## Fig. 4

3 2 6 5 4

1

## Fig. 5

**Fig. 6**

**Fig. 7**

**Fig. 8**

**Fig. 9**

**Fig. 10**

**Fig. 11**

Fig. 12

Fig. 13

# Fig. 14

# Fig. 15

**Fig. 16**

**Fig. 17**

**Fig. 18**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5587620 A
- US 20010017504 A
- US 5166646 A
- US 5339051 A
- EP 0631384 A1
- US 5617065 A
- DE 10153434
- EP 0963000 A
- WO 03069776 A2

**Non-patent literature cited in the description**

- **S. V. Krishnaswamy et al.** Film Bulk Acoustic Wave Resonator Technology. *Film Bulk Acoustic Wave Resonator Technology,* 1990, 529-536
- **J. J. Lutsky et al.** *A Sealed Cavity TFR Process for RF Bandpass Filters*
- **K. M. Lakin.** Thin Film Resonators and Filters. *IEEE Ultrasonics Symposium,* 1999, 895-906
- **Markku Ylilammi et al.** Thin Film Bulk Acoutic Wave Filter. *IEEE Transactions on UFFC,* April 2002, vol. 49 (4), 535-539
- **R. Lanz et al.** Surface Micromachined BAW Resonators Based on AIN. *IEEE Ultrasonics Symposium,* 2002, 981-983
- **Motoaki Hara et al.** Aluminum Nitride Based Thin Film Bulk Acoustic Resonator Using Germanium Sacrificial Layer Etching. *The 12th International Conference on Solid State Sensors, Actuators and Microsystems,* 2003
- Modeling Piezoelectric and Piezomagnetic Devices and Structures via Equivalent Networks. *IEEE UFFC Transactions,* September 2001, vol. 48 (5), 1189-1240
- **A.P.S Khanna et al.** A 2GHz Voltage Tunable FBAR Oscillator. *IEEE MTT-S Digest,* 717-720
- **A. Ballato.** Modelling Piezoelectric and Piezomagnetic Devices and Structures via Equivalent Networks. *IEEE UFFC Transactions,* September 2001, vol. 48 (5), 1189-1240